# EUROPÄISCHE PATENTSCHRIFT

(11) **EP 0 603 532 B1**
(45) Veröffentlichungstag und Bekanntmachung des Hinweises auf die Patenterteilung: **20.09.2000**
(21) Anmeldenummer: 93118325.5
(22) Anmeldetag: 12.11.1993
(51) Int. Cl.: G02F 1/13, G02F 1/1345, H01R 4/04, H05K 3/42

(54) **Flüssigkristall-Anzeigevorrichtung**
Liquid crystal display device
Dispositif d'affichage à cristal liquide

(30) Priorität: 19.12.1992 DE 9217429 U
(43) Veröffentlichungstag der Anmeldung: 29.06.1994
(73) Patentinhaber: Schauer, Gernot Dr., D-89518 Heidenheim (DE)
(72) Erfinder: Rapp, Bertram, Dr., D-86152 Augsburg (DE)
(74) Vertreter: Charrier, Rolf, Dipl.-Ing.

(56) Entgegenhaltungen:
- EP-A- 0 337 775
- EP-A- 0 422 906
- US-A- 4 766 426
- US-A- 5 130 833
- PATENT ABSTRACTS OF JAPAN vol. 10, no. 260 (P-494)(2316) 5. September 1986 & JP-A-61 087 133 (CITIZEN WATCH) 2. Mai 1986
- PATENT ABSTRACTS OF JAPAN vol. 14, no. 426 (P-1105)13. September 1990 & JP-A-02 166 492 (FUJITSU) 27. Juni 1990
- PATENT ABSTRACTS OF JAPAN vol. 16, no. 430 (P-1417)9. September 1992 & JP-A-04 147 219 (HITACHI) 20. Mai 1992

## Beschreibung

Gegenstand der vorliegenden Erfindung ist eine Flüssigkristall-Anzeigevorrichtung nach dem Oberbegriff des Anspruchs 1.

Eine derartige Flüssigkristall-Anzeigevorrichtung ist beispielsweise in der DE 40 35 360 A1 beschrieben. Bei dieser Vorrichtung befindet sich zwischen zwei Glasplatten, welche auf ihren einander zugewandten Oberflächen strukturierte, leitfähige Schichten aus Indiumzinnoxid (Indium Tin Oxide = ITO) aufweisen, ein Flüssigkristall. Dieser Flüssigkristall kann durch Anlegen eines von den ITO-Schichten ausgehenden und senkrecht zu den Glasplatten verlaufenden elektrischen Feldes derart beeinflußt werden, daß sich die optischen Eigenschaften der Anordnung ändern. Es sind heute eine Vielzahl elektrooptischer Effekte in Flüssigkristallen bekannt und werden auch in Flüssigkristall-Anzeigen eingesetzt. Dies sind beispielsweise sogenannte Drehzellen (TN-Zellen = Twisted Nematic-Zellen), Supertwistzellen (STN-Zellen), Farbstoffzellen, homoötrop orientierte Zellen, DAP-Zellen (= Deformation of Aligned Phases) und ferroelektrische Zellen. Der elektrooptische Effekt kann dabei in vielen Fällen durch Einsatz von Polarisations- und/oder Farbfiltern verbessert werden. Durch geeignete Strukturierung der leitfähigen ITO-Schichten lassen sich beliebig geformte Anzeigen realisieren, beispielsweise Segmentanzeigen, Matrixanzeigen oder anders geformte Muster. Zur Kontaktierung dieser ITO-Schichten steht eine der beiden Glasplatten an mindestens einer Kante der Vorrichtung über die andere Glasplatte hervor. Die leitfähigen Schichten aus ITO sind aus der eigentlichen Flüssigkristallzelle, welche randseitig durch einen Kleberand abgeschlossen ist, auf den hervorstehenden Bereich herausgeführt. In diesem Bereich erfolgt die Kontaktierung, wobei an die herausgeführten Leiterbahnen die Ansteuersignale angelegt werden. Die ITO-Schichten auf der anderen Glasplatte werden durch Brücken aus leitfähigem Klebstoff von der den Überstand bildenden Glasplatte angesteuert.

Als besonders vorteilhafte Variante zur Ansteuerung der herausgeführten Leiterbahnen hat sich die in der genannten Druckschrift beschriebene Chip-On-Glass-Technik herausgebildet. Dabei werden die herausgeführten Leiterbahnen zunächst mit metallischen Schichten versehen, auf welche dann unmittelbar die Ansteuerungsschaltkreise aufgebracht werden.

Die Chip-On-Glass-Technik weist verschiedene Nachteile auf. Beispielsweise ist die Metallisierung der herausgeführten ITO-Schichten ein Verfahrensschritt, der bei der Flüssigkristallanzeigenproduktion normalerweise nicht vorkommt, weshalb eine eigene Metallisierungsstation vorzusehen ist. Außerdem ist die Gesamtausbeute der produzierten Anzeigen zu niedrig, da sie sich multiplikativ aus der Ausbeute der reinen Flüssigkristallanzeige und der die Ansteuerschaltkreise umfassenden Ansteuereinheit zusammensetzt. Eine Reparatur einer einmal bestückten Flüssigkristallanzeige, z.B. bei einem defekten Ansteuerschaltkreis, ist unwirtschaftlich, da dieser von Hand zu entfernen und durch einen neuen Schaltkreis zu ersetzen wäre.

Ausgehend von dieser bekannten Chip-On-Glass-Technik sind bei der JP 3-89321 A2 die Ansteuerschaltkreise auf einer eigenen Leiterplatte in SMD-Technik (SMD = Surface Mounted Device) angeordnet. Die zur Flüssigkristallanzeige führenden Leiterbahnen auf dieser Leiterplatte führen von dem Kontaktfüßchen der Ansteuerschaltkreise in den Bereich einer Kante der Leiterplatte und korrespondieren mit den herausgeführten ITO-Bahnen des überstehenden Teils der einen Glasplatte der Flüssigkristallanzeige. Dieser Randbereich der Leiterplatte ist mit dem überstehenden Teil der Glasplatte so verklebt, daß gegenüber jeder leitfähigen ITO-Schicht des überstehenden Teils der Glasplatte eine Leiterbahn der Leiterplatte angeordnet ist. Dabei enthält der Klebstoff leitfähige Partikel, deren Größe etwa dem Abstand zwischen überstehender Platte und Leiterplatte entspricht. Es sind jedoch so wenig dieser Partikel vorhanden, daß keine laterale Leitfähigkeit stattfindet, sondern nur eine Leitfähigkeit senkrecht zur Oberfläche der Platte bzw. der Leiterplatte vorhanden ist. Auf diese Weise erfolgt eine Kontaktierung der Leiterbahnen auf der Leiterplatte mit den korrespondierenden Leiterbahnen auf dem hervorstehenden Teil der Glasplatte.

Verglichen mit der Chip-On-Glass-Technik weist diese Anordnung den Vorteil auf, daß keine zusätzliche Metallisierung der ITO-Schichten notwendig ist, die Gesamtausbeute höher ist, weil defekte Anzeigen oder Ansteuereinheiten bereits vor dem Zusammenbau entfernt werden können und eine Reparatur- und Austauschmöglichkeit der Leiterplatte mit den Ansteuerschaltkreisen durch Lösen der Klebeverbindung möglich ist.

Die in der JP 3-89321 A2 beschriebene Flüssigkristall-Anzeigevorrichtung weist jedoch auch Nachteile auf Der Hauptnachteil besteht darin, daß die seitlich an die eigentliche Flüssigkristallanzeige angesetzte Leiterplatte mit den Ansteuerschaltkreisen einen erheblichen Raumbedarf hat. Dies ist insbesonders dann unerwünscht, wenn mehrere Anzeigeeinheiten zu einer Anzeigetafel zusammengesetzt werden sollen und ein unmittelbarer Anschluß gewünscht ist.

Bei der EP-A-0 337 775 sind Ansteuerungsschaltkreise nicht auf metallischen Leiterbahnen angeordnet, sondern auf einem tape carrier. Um die elektrische Kontaktierung zu ermöglichen, sind Drahtanschlüsse notwendig, welche ebenfalls von dem tape carrier gehalten werden. Die Drahtanschlüsse sind gegenüber Verrutschen empfindlich und können nicht exakt positioniert werden, weshalb eine zuverlässige und genaue Position auch mehrerer Chips auf einer Anzeigevorrichtung nur unter großen Schwierigkeiten möglich ist. Ferner können defekte Chips bei der EP-A-0 337 775 nicht ohne weiteres wieder entfernt und ersetzt werden, sondern es muß die gesamte Anzeige weggeworfen werden, falls ein Chip sich als defekt herausstellt.

Die US-A-5,130,833 zeigt eine Flüssigkristallanzeigevorrichtung mit zwei den Flüssigkristall einschließenden Platten, deren einander zugewandte Oberflächen strukturierte, leitfähige Schichten aufweisen, wobei im Bereich einer Kante die zu kontaktierende Platte über die andere Platte hervorsteht und der auf diese Weise gebildete Überstand Ansteuerschaltkreise trägt, die auf metallischen Leiterbahnen angeordnet sind, welche mit Hilfe eines ausschließlich senkrecht zur Oberfläche der Platten elektrisch leitfähigen Klebstoffes mit dem Überstand verklebt sind. Bei dieser Druckschrift findet jedoch eine Metallisierung der leitfähigen ITO-Schichten, beispielsweise mit Nickel oder Gold, statt, wobei vorzugsweise sogar eine zweifache Metallisierung, nämlich zunächst mit Nickel und anschließend mit Gold erfolgt. Wie oben erwähnt, ist die Metallisierung der herausgeführten ITO-Schichten ein weiterer Verfahrensschritt, bei der Doppelmetallisierung fallen sogar zwei zusätzliche Verfahrensschritte an. Auf die Nachteile wurde bereits unter Bezugnahme auf die Chip-On-Glass-Technik eingegangen.

Es besteht daher die Aufgabe, eine Flüssigkristall-Anzeigevorrichtung, so weiterzubilden, daß ihre Herstellung möglichst einfach und billig und mit möglichst wenigen Verfahrensschritten ausführbar ist.

Gelöst wird diese Aufgabe durch die kennzeichnenden Merkmale des Anspruchs 1. Vorteilhafte Ausgestaltungen sind den Unteransprüchen entnehmbar.

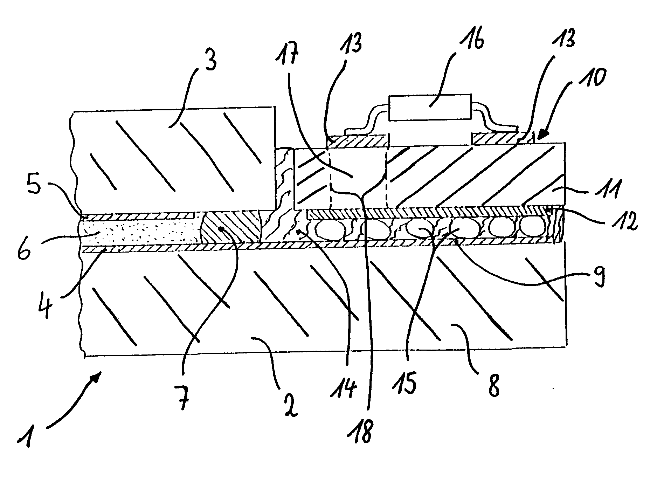

Ein Ausführungsbeispiel der Erfindung wird im folgenden unter Bezugnahme auf die Zeichnung näher beschrieben. Diese zeigt einen Querschnitt durch den Randbereich einer nicht beanspruchten Flüssigkristall-Anzeigevorrichtung, zusammen mit der Ansteuereinheit.

Die Flüssigkristall-Anzeigevorrichtung 1 umfaßt eine erste Glasplatte 2 und eine zweite Glasplatte 3, wobei beide Glasplatten 2 und 3 an ihren einander zugewandten Oberflächen mit strukturierten Schichten aus Indiumzinnoxid (ITO) 4 und 5 versehen sind. Der dargestellte Querschnitt verläuft durch einen Bereich der Anzeigevorrichtung 1, welcher auf beiden Glasplatten 2 und 3 ITO-Schichten 4 und 5 trägt. Auf den beiden ITO-Schichten 4 und 5 befinden sich (nicht dargestellte) Orientierungsschichten, beispielsweise aus einem Polymer, welche zur Orientierung des Flüssigkristalls 6, welcher sich zwischen den beiden Glasplatten 2 und 3 befindet, in geeigneter Weise - beispielsweise durch Reiben - vorbehandelt sind. Der Flüssigkristall 6 ist für TN-Zellen, Supertwist-Zellen, Farbstoffzellen und Doppelbrechungszellen ein nematischer Flüssigkristall, für ferroelektrische Zellen ein smektischer Flüssigkristall. Der Flüssigkristall 6 ist im Randbereich der Anzeigevorrichtung 1 durch einen Kleberand 7 vollständig eingeschlossen. Zwischen der ITO-Schicht 4 der ersten Glasplatte 2 und der ITO-Schicht 5 der zweiten Glasplatte 3 bestehen an mehreren Stellen der Anzeigevorrichtung 1 (nicht dargestellte) Verbindungen aus leitfähigem Klebstoff, wodurch die zweite ITO-Schicht 5 über die erste ITO-Schicht 4 kontaktiert wird.

Die erste Glasplatte 2 ist im Bereich der dargestellten Kante der Anzeigevorrichtung 1 durch einen Überstand 8 gegenüber der zweiten Glasplatte 3 verlängert. Auf diesen Überstand 8 sind auch Leiterbahnen 9 aus der ersten ITO-Schicht 4 herausgeführt. Oberhalb des Überstandes 8 befindet sich die Ansteuereinheit 10, welche eine Leiterplatte 11 mit beidseitig darauf angeordneten Leiterbahnen 12 und 13 umfaßt, wobei die an der Unterseite der Leiterplatte 11 angeordneten Leiterbahnen 12 mit den auf den Überstand 8 herausgeführten ITO-Bahnen 9 der ersten Glasplatte 2 korrespondieren, d.h. es befindet sich jeweils eine Leiterbahn 12 über einer korrespondierenden ITO-Bahn 9. Die Kontaktierung zwischen den ITO-Bahnen 9 und den Leiterbahnen 12 erfolgt durch einen Klebstoff 14 mit anisotroper Leitfähigkeit. Hierzu sind in dem Klebstoff 14 elektrisch leitende Partikel 15 enthalten, deren Größe etwa dem gewünschten Abstand zwischen dem Überstand 8 und der Leiterplatte 11 entspricht. Die Dichte dieser Partikel 15 ist dabei so gewählt, daß keine laterale Leitfähigkeit stattfindet.

Auf der Oberseite der Leiterplatte 11 befinden sich Leiterbahnen 13, auf welche die Ansteuerschaltkreise 16 in TAB-Technik (Tape Automated Bonding) aufgelötet sind. Die Tape Automated Bonding-Technik ist beispielsweise im Firmenprospekt Ref. No. WT241C der Sharp Corporation vom März 1990 beschrieben. Bei dieser Technik liegen die Ansteuerschaltkreise mit ihren Anschlußdrähten auf einem Film, von welchem sie ausgestanzt und auf die Leiterplatte übertragen werden. Die Verbindung zwischen den Anschlußdrähten des Ansteuerschaltkreises mit den Leiterbahnen der Leiterplatte erfolgt durch Anwendung von Hitze mithilfe eines Stempels.

Die Kontaktierung der Leiterbahnen 13 erfolgt über Bohrungen 17, welche durch die Leiterplatte 11 hindurch verlaufen und an ihren Innenwandungen 18 einen leitfähigen Überzug aufweisen. Dieser Überzug kann beispielsweise eine Metallbedampfung aus Gold oder einem anderen Metall sein.

Zur Ansteuerung der Anzeigevorrichtung 1 werden die Ansteuerschaltkreise 16 durch (nicht dargestellte) Versorgungsleitungen mit den zur Ansteuerung notwendigen Signalen versorgt. Die Ansteuerschaltkreise 16 erzeugen hieraus die Ansteuersignale zur Ansteuerung der Vorrichtung 1 und geben diese auf die Leiterbahnen 13. Von dort aus gelangen die Signale durch die leitfähigen Innenseiten 18 der Bohrungen 17 zu den an der Unterseite der Leiterplatte 11 angebrachten Leiterbahnen 12 und werden von hier über den anisotrop leitenden Klebstoff 14 auf die entsprechenden ITO-Bahnen 9 gebracht. Diese führen unmittelbar in die eigentliche Anzeigevorrichtung und steuern diese an.

Die Bohrungen 17 können nicht nur mit leitfähigen Beschichtungen ihrer Innenseiten 18 versehen, sondern vollständig mit leitfähigem Material gefüllt sein. Ebenfalls ist es möglich, dem Klebstoff zusätzliche steife Partikel zuzusetzen, deren Größe den Abstand zwischen dem Überstand 8 und der Leiterplatte 11 bestimmt, wobei in diesem Fall die leitfähigen Partikel 15 vorzugsweise etwas größer und elastisch nachgiebig sind.

Sowohl der Klebstoff zur Bildung des Kleberandes 7 als auch der Klebstoff des anisotrop leitenden Klebers 14 ist vorzugsweise ein thermisch aushärtbarer Klebstoff, kann jedoch auch ein durch ultraviolette Strahlung aushärtbarer Klebstoff sein.

Alternativ zur Montage der Ansteuerschaltkreise 16 in TAB-Technik können diese auch in der bekannten SMD-Technik (Surface Mounted Device) angebracht werden. Weiterhin ist es möglich, die Ansteuerschaltkreise 16 in der sogenannten Flip-Chip-Technik auf der Leiterplatte 11 angebracht werden. Hierbei wird lediglich der Chip ohne Gehäuse und ohne innere Bond-Verbindungen unmittelbar auf die Leiterplatte 11 aufgebracht und mit den Leiterbahnen gebondet.

Die Leiterplatte 11 besteht beispielsweise aus Pertinax oder Keramik, sie kann aber auch aus einem weichen Material, wie einer Polyesterfolie, bestehen. Der typische Abstand zwischen der Leiterplatte 11 und dem Überstand 8 beträgt - wie der typische Abstand einer nematischen Flüssigkristall-Anzeigevorrichtung - etwa 5 bis 15 µm.

Bei der dargestellten Flüssigkristall-Anzeigevorrichtung befindet sich die Leiterplatte 11 vollständig über dem Überstand 8. Die Ansteuerungseinheit der Flüssigkristallanzeige 1 ist damit vollständig in diese integriert und hat keinen darüberhinaus reichenden Platzbedarf.

In der bevorzugten erfindungsgemäßen Ausführungsform fallen die auf der Oberseite der Leiterplatte 11 angeordneten Leiterbahnen 13 auch mit den an ihrer Unterseite angeordneten Leiterbahnen 12 zusammen. In diesem Falle fehlt die Leiterplatte 11 und die zusammenfallenden Leiterbahnen 12 bzw. 13 sind unmittelbar auf die elektrisch leitfähige Schicht 9 des Überstandes 8 aufgeklebt. Das Aufkleben der Leiterbahnen 12 bzw. 13 erfolgt in diesem Fall vorzugsweise mit Hilfe eines Trägers, auf welchem die Leiterbahnen angeordnet sind. Dieser Träger kann beispielsweise als Film ausgebildet sein.

## Patentansprüche

1. Flüssigkristall-Anzeigevorrichtung (1) mit zwei den Flüssigkristall (6) einschließenden Platten (2, 3), deren einander zugewandte Oberflächen strukturierte, leitfähige, aus Indium-Zinn-Oxid bestehende Schichten (4, 5, 9) aufweisen, wobei im Bereich mindestens einer Kante der Vorrichtung (1) die zu kontaktierende Platte (2) über die andere Platte (3) hervorsteht und der so gebildete Überstand (8) Ansteuerungsschaltkreise (16) trägt, **dadurch gekennzeichnet**, daß die Ansteuerungsschaltkreise (16) unmittelbar auf metallischen Leiterbahnen (12) angeordnet sind, welche mit Hilfe eines ausschließlich senkrecht zur Oberfläche der Platten (2, 3) elektrisch leitfähigen Klebstoffes (14) unmittelbar auf die elektrisch leitfähige Schicht des Überstandes (8) aufgeklebt sind.

2. Flüssigkristall-Anzeigevorrichtung nach Anspruch 1, **dadurch gekennzeichnet**, daß der Klebstoff (14) leitfähige Partikel (15) enthält, deren Größe etwa dem Abstand zwischen Überstand (8) und metallischen Leiterbahnen (12) entspricht.

3. Flüssigkristall-Anzeigevorrichtung nach Anspruch 2, **dadurch gekennzeichnet**, daß die leitfähigen Partikel (15) elastisch sind und der Klebstoff (14) zusätzlich steife, etwas kleinere Partikel enthält, deren Größe den Abstand zwischen Überstand (8) und metallischen Leiterbahnen (12) bestimmt.

4. Flüssigkristall-Anzeigevorrichtung nach einem der voranstehenden Ansprüche, **dadurch gekennzeichnet**, daß der Klebstoff (14) ein thermisch aushärtbarer und durch ein geeignetes Lösungsmittel lösbarer Klebstoff ist.

## Claims

1. Liquid crystal display device (1) with two sheets (2,3) which enclose the liquid crystal (6) and the facing surfaces of which exhibit structured conductive layers (4,5,9) made of indium tin oxide, whereby in the area of at least one edge of the device (1) the sheet (2) to be contacted projects beyond the other sheet (3) and the projection (8) so formed carries actuating circuits (16), characterised in that the actuating circuits (16) are disposed directly on metal conductor tracks (12) which are bonded directly onto the electrically conductive layer of the projection (8) with the aid of an adhesive (14) which is electrically conductive solely perpendicular to the surface of the sheets (2,3).

2. Liquid crystal display device according to claim 1, characterised in that the adhesive (14) contains conductive particles (15) the size of which roughly corresponds to the distance between the projection (8) and the metal conductor tracks (12).

3. Liquid crystal display device according to claim 2, characterised in that the conductive particles (15) are elastic and the adhesive (14) additionally contains rigid somewhat smaller particles the size of which determines the distance between the projection (8) and the metal conductor tracks (12).

4. Liquid crystal display device according to one of the preceding claims, characterised in that the adhesive (14) is a thermosetting adhesive which is soluble by an appropriate solvent.

## Revendications

1. Dispositif de visualisation ou d'affichage à cristal liquide (1) comportant deux plaquettes (2, 3) qui enferment le cristal liquide (6) et dont les surfaces par se faisant face comportent des couches (4, 5, 9) conductrices, en oxyde d'indium et de zinc, et structurées, la plaquette (2) devant faire l'objet d'une mise en contact faisant saillie, dans la zone d'au moins un bord du dispositif (1), au-dessus de l'autre plaquette (3) et la partie en saillie (8) ainsi formée portant des circuits de commande (16), caractérisé en ce que les circuits de commande (16) sont disposés directement sur des pistes conductrices métalliques (12) qui sont collées directement sur la couche électriquement conductrice de la partie en saillie (8) et au moyen d'une colle (14) qui est exclusivement électriquement conductrice perpendiculairement à la surface des plaquettes (2, 3).

2. Dispositif de visualisation ou d'affichage à cristal liquide suivant la revendication 1, caractérisé en ce que la colle (14) contient des particules conductrices (15) dont la taille correspond approximativement à la distance séparant la partie en saillie (8) des pistes conductrices métalliques (12).

3. Dispositif de visualisation ou d'affichage à cristal liquide suivant la revendication 2, caractérisé en ce que les particules conductrices (15) sont élastiques et la colle (14) contient des particules rigides légèrement plus petites dont la taille détermine la distance séparant la partie en saillie (8) des pistes conductrices métalliques (12).

4. Dispositif de visualisation ou d'affichage à cristal liquide suivant l'une des revendications précédentes, caractérisé en ce que la colle (14) est une colle thermodurcissable pouvant être dissoute au moyen d'un solvant approprié.
